Europäisches Patentamt

European Patent Office

Office européen des brevets

(19)

(11) Veröffentlichungsnummer: **0 237 732 B1**

# EUROPÄISCHE PATENTSCHRIFT

(12)

(45) Veröffentlichungstag der Patentschrift: **16.10.91**

(21) Anmeldenummer: **87101035.1**

(22) Anmeldetag: **26.01.87**

(51) Int. Cl.⁵: **G01R 1/067**, G01R 1/073, H01R 11/18

(54) **Federkontaktstift für Prüfvorrichtungen.**

(30) Priorität: **27.02.86 DE 3606416**

(43) Veröffentlichungstag der Anmeldung:
**23.09.87 Patentblatt 87/39**

(45) Bekanntmachung des Hinweises auf die
Patenterteilung:
**16.10.91 Patentblatt 91/42**

(84) Benannte Vertragsstaaten:
**AT CH DE FR GB IT LI NL**

(56) Entgegenhaltungen:
**EP-A- 0 036 804      DE-A- 2 426 337**
**DE-A- 2 920 872      DE-A- 3 340 431**
**GB-A- 2 113 483      US-A- 3 562 643**
**US-A- 4 029 375**

(73) Patentinhaber: **Feinmetall Gesellschaft mit beschränkter Haftung**
**Zeppelinstrasse 2**
**W-7033 Herrenberg(DE)**

(72) Erfinder: **Krüger, Gustav, Dr.**
**Danziger Strasse 1**
**W-7033 Herrenberg(DE)**

(74) Vertreter: **Grosse, Rainer, Dipl.-Ing. et al**
**Gleiss & Grosse Patentanwaltskanzlei Silberburgstrasse 187**
**W-7000 Stuttgart 1(DE)**

**Beschreibung**

Die Erfindung betrifft einen Federkontaktstift gemäß dem Oberbegriff des Anspruchs 1.

Prüfvorrichtungen, für die derartige Federkontaktstifte bestimmt sind, dienen der Prüfung von Prüflingen auf elektrische Fehlerfreiheit. Jeder Federkontaktstift hat meist viele Tausende, oft sogar Millionen von Prüflingen zu kontaktieren.

Ein Federkontaktstift der eingangs genannten Art ist aus der US-PS 3,562,643 bekannt. Er besitzt eine Hülsen-Kolben-Anordnung, das heißt, innerhalb einer Hülse ist ein Kolben eines Kontaktelements präzise geführt, wobei der Kolben mittels einer Schraubendruckfeder beaufschlagt ist. Damit die Schraubendruckfeder den Kolben nicht aus der Hülse herausdrückt, ist das entsprechende Hülsenende umgebördelt. Die Herstellung der Hülsen-Kolben-Anordnung sowie der Bördelvorgang sind relativ arbeitsaufwendig. Dies führt zu entsprechend hohen Kosten. Es liegt jedoch eine präzise Führung des Kontaktelements vor, die es erlaubt, auch kleinste Prüfkontaktpunkte eines Prüflings mit guter Kontaktgabe punktgenau zu kontaktieren.

Aus der US-PS 4,029,375 ist eine Schraubendruckfeder bekannt, die der elektrischen Kontaktierung dient. Diese Schraubendruckfeder liegt in einer Stufenbohrung, wobei -entsprechend der Kontur der Stufenbohrung- die Schraubendruckfeder eine entsprechende Ausbildung mit zwei unterschiedlichen Windungsdurchmessern aufweist. Die Stufenbohrung durchsetzt eine Isolierstoffplatte, auf die beidseitig Deckplatten aufgebracht sind, die Kontaktflächen aufweisen. Die Kontaktflächen werden über die zusammengedrückte Schraubendruckfeder miteinander elektrisch verbunden.

Prüfvorrichtungen der eingangs genannten Art weisen im allgemeinen Prüfadapter oder dergleichen mit einer Vielzahl von dem Kontaktieren von zu prüfenden Leiterplatten oder sonstigen Prüflingen dienenden Federkontaktstiften auf, siehe zum Beispiel: Krüger "Prüfmittel zur Prüfung von Leiterplatten für Uhren", Jahrbuch der deutschen Gesellschaft für Chronometrie, Bd. 30, 1979, S. 269 - 276.

Es sind Federkontaktstifte bekannt (DE-OS 28 52 886; Krüger w.o.), die eine Hülse aufweisen, in die eine zylindrische Schraubendruckfeder eingesetzt ist, die einen in der Hülse gleitbar angeordneten Kolben des Kontaktelementes federbelastet und sich an einem in der Hülse fest eingesetzten Bodenstück abstützt. Dieses Kontaktelement weist eine am Kolben koaxial zu ihm angeordnete Stange auf, an der ein Kontaktkopf fest angeordnet ist, welcher zum in Kontakt kommen mit den zu kontaktierenden Prüflingen bestimmt ist. Derartige Federkontaktstifte sind in der Herstellung relativ teuer. So muß die Hülse nach dem Einsetzen des Kolbens an dem dem Kolben benachbarten Ende nach innen etwas umgebördelt werden, damit der Kolben durch die vorgespannte Schraubendruckfeder nicht aus der Hülse herausgedrückt wird.

Dieses Bördeln ist relativ arbeitsaufwendig. Auch verursacht dieses Kontaktelement relativ hohe Kosten infolge seiner außerordentlich kleinen Durchmesser, da die Hülsen solcher Federkontaktstifte nur sehr geringe maximale Durchmesser von im allgemeinen höchstens 1,5 mm aufweisen dürfen. Dagegen sind diese Federkontaktstifte zwecks ausreichend starker axialer Eigenfederung und ausreichend hohen Kontaktkräften, die meist mehr als hundert cN betragen sollen, relativ lang ausgebildet, bspw. meist ca. 1 bis 5 cm.

Es ist deshalb eine Aufgabe der Erfindung, einen Federkontaktstift der im Oberbegriff des Anspruches 1 genannten Art zu schaffen, der kostengünstiger herstellbar ist und dennoch eine präzise Kontaktierung exmöglicht.

Diese Aufgabe wird erfindungsgemäß durch einen Federkontaktstift gemäß Anspruch 1 gelöst.

Bei der Herstellung dieses Federkontaktstiftes ist kein Bördelvorgang erforderlich. Auch ist die Schraubenfeder des Kontaktelementes, welches das Kontaktelement allein oder zusammen mit einem an ihm angeordneten Kontaktkopf bilden kann, kostengünstig in einem Arbeitsgang zusammen mit der Schraubendruckfeder durch Wickeln herstellbar, da diese Schraubenfeder und die Schraubendruckfeder eine einzige einstückige Feder bilden. Sehr vorteilhaft ist dabei auch, daß die Schraubenfeder außerhalb der Hülse aus ihrer geraden Richtung seitlich ohne zu knicken ausgebogen werden kann, was sich beim Kontaktieren von Prüflingen günstig auswirkt, indem bspw. dann, wenn das Kontaktelement dem Kontaktieren von zu ihm exzentrisch angeordneten Bohrungsrändern dient, sich dann das freie Kontaktende dieses Kontaktelementes in der Bohrung von selbst zentriert und hierdurch optimal sicherer Kontakt erreicht wird. Auch wird der Bohrungsrand des Prüflings gleichmäßig belastet und es besteht nicht mehr folgende Beschädigungsgefahr der bekannten, Kolben aufweisenden Federkontaktstifte: Wenn die Kontaktspitze des Kontaktelementes eines solchen vorbekannten Federkontaktstiftes mit Kolben exzentrisch auf einen Bohrungsrand einer Leiterplatte oder dergl. auftrifft, kann dieses Kontaktelement nicht radial ausweichen und versucht deshalb den Kolben in der Hülse schräg zu stellen mit der Folge hoher Reibung, die unter Umständen sogar zum Klemmen des Kolbens führen kann. Es besteht hierdurch Beschädigungsgefahr des Kontaktelementes bis zu seinem Brechen und es kann auch zu Überlastung des kontaktierten Bohrungsrandes der Leiterplatte oder dergl. kommen. Diese Nachteile lassen sich also durch die Erfindung auf einfache Weise vermeiden, wobei durch die aneinanderliegenden Windungen der Schraubenfeder eine präzise Führung in der Hülse gewährleistet ist, da der Außendurchmesser der Schraubenfeder unabhängig von der Stellung des Kontaktelements stets sein präzises Maß beibehält.

Auch besteht der erfindungsgemäße Federkontaktstift aus relativ wenigen Teilen. Im einfachsten Fall besteht er nur aus der Hülse und der eine einstückige Feder bildenden Schraubendruckfeder und Schraubenfeder, also nur aus zwei Teilen. In diesem Fall kann zweckmäßig vorgesehen sein, daß das rückwärtige Ende der Schraubendruckfeder in der Hülse fest angeordnet ist, was bspw. durch Schweißen oder Löten oder formschlüssiges Halten in der Hülse erreicht werden kann. Es ist jedoch auch möglich, in der Hülse ein Auflager für das rückwärtige Ende der Schraubendruckfeder anzuordnen, das zweckmäßig einen Stab aufweist, mit dem es in die Schraubendruckfeder zu deren Halterung koaxial zu ihr eingreift.

Die Hülse kann zweckmäßig nur ein Rohr sein, also beidseitig offen sein. Die von der Schraubenfeder durchdrungene Mündung der Hülse braucht nicht nach innen umgebördelt zu werden, sondern kann zumindest denselben lichten Innendurchmesser aufweisen, wie der vorzugsweise kreiszylindrische Bereich der Hülse, in dem sich die Schraubendruckfeder und der betreffende jeweilige Bereich der Schraubenfeder befindet. Ein Vorteil ist auch, daß das vordere Ende der Hülse nach außen zur Bildung eines Flansches umgebogen sein kann, was auf einfache Weise herstellbar ist und ermöglicht, daß diese Hülse in eine Aufnahmebohrung einer Platte des Prüfadapters so eingesetzt sein kann, daß sie mit dem Flansch auf dieser Platte aufsitzt und so für sie keine zusätzliche Befestigung an dieser Platte notwendig ist. Bei dem vorbekannten Federkontaktstift nach der DE-OS 28 52 886 ist dies dagegen nicht möglich.

Das rückwärtige Ende der Hülse kann direkt das Anschlußende des Federkontaktstiftes sein oder es kann auch vorgesehen sein, daß an der Hülse oder in der Hülse ein gesondertes Anschlußende eingesetzt ist, bspw. ein Draht, ein Stecker oder dergl..

Es kann in vielen Fällen auch zweckmäßig vorgesehen sein, daß die Hülse an ihrem hinteren Ende einen sie ganz oder weitgehend schließenden Boden oder einen Innenflansch aufweist. Die Schraubendruckfeder kann dann auf diesem Boden oder diesem Innenflansch aufsitzen.

Die Schraubenfeder ist so steif und/oder durch einen in sie eingesteckten Stab, vorzugsweise einen Schaft eines Kontaktkopfes des Kontaktelementes versteift, daß ihr über die Hülse überstehender Bereich im Ruhezustand in der Betriebsstellung des Kontaktstiftes gerade und in Fluchtung mit der Hülse ist, damit sie beim Prüfen von Prüflingen genau auf die vorgesehene, zu kontaktierende Stelle des jeweiligen Prüflinges auftrifft. Die vorgesehene Betriebsstellung des Federkontaktstiftes ist normalerweise vertikal.

Auch ist die Schraubenfeder des erfindungsgemäßen Federkontaktstiftes so steif und/oder durch einen in sie eingesteckten Stab, vorzugsweise einen Schaft eines Kontaktkopfes des Kontaktelementes versteift, daß ihr über die Hülse überstehender Bereich durch die beim Kontaktieren von Prüflingen auf sie einwirkenden Kräfte nicht geknickt wird, sondern gerade bleibt bzw. beim Kontaktieren von zu ihr exzentrischen Bohrungsrändern von Prüflingen sich schwach biegen kann, ohne zu knicken, so daß sie die von Prüflingen auf sie ausgeübten axialen Kräfte stets ohne zu knicken aushält und so zur Schraubendruckfeder weiterleiten kann. Dabei kann gemäß einer baulich besonders einfachen Ausführungsform der Erfindung vorgesehen sein, daß der Innenraum der Schraubenfeder frei von irgendwelchen anderen Teilen ist. Die Eigensteifigkeit der Schraubenfeder ist dann also so groß vorzusehen, daß sie im Betrieb nicht knickt und in der Betriebsstellung im unbelasteten Zustand gerade und in Fluchtung mit der Hülse ist. Es kann jedoch bei einer ebenfalls vorteilhaften Ausführungsform auch vorgesehen sein, sie, wie erwähnt, durch einen Schaft eines Kontaktkopfes, welcher Schaft sich vorzugsweise bis in die Hülse hinein erstrecken kann, oder einen sonstigen in sie eingesteckten Stab zu versteifen.

Erfindungsgemäße Federkontaktstifte können vorzugsweise folgende Dimensionierung erhalten:

Das Verhältnis der Länge des über die Hülse überstehenden Bereiches der unbelasteten Schraubenfeder zu dem maximalen Windungsaußendurchmesser dieses Bereiches kann vorzugsweise mindestens 4 : 1, besonders zweckmäßig mindestens 5 : 1 betragen.

Der Windungsaußendurchmesser der Schraubenfeder kann vorzugsweise mindestens 0,4 mm und/oder vorzugsweise maximal 2 mm, besonders günstig 0,8 - 1,2 mm betragen.

Die Länge des über die Hülse überstehenden Bereiches der Schraubenfeder in deren unbelastetem Zustand kann vorzugsweise maximal 8 mm und/oder vorzugsweise mindestens 2 mm, besonders zweckmäßig 4 - 6 mm betragen.

Der die Schraubenfeder und die Schraubendruckfeder bildende Federdraht, der vorzugsweise konstanten kreisrunden Querschnitt aufweisen kann, kann vorzugsweise maximal 0,18 mm und/oder vorzugsweise mindestens 0,07 mm, besonders zweckmäßig 0,08 - 0,15 mm betragen.

Der oder die Außendurchmesser des oder der zylindrischen Bereiche der Hülse können vorzugsweise maximal 2,5 mm und/oder vorzugsweise mindestens 0,5 mm, besonders zweckmäßig 0,6 - 1,4 mm betragen.

Die Länge der aus der Schraubendruckfeder und der Schraubenfeder bestehenden Feder (Gesamtfeder) kann vorzugsweise mindestens 1 cm und/oder vorzugsweise maximal 6 cm, besonders zweckmäßig 1,5 bis 5 cm betragen.

Die Wandstärke der Hülse kann vorzugsweise maximal 0,25 mm, besonders zweckmäßig 0,1 bis 0,2 mm betragen.

Die Länge der Schraubendurckfeder kann vorzugsweise mindestens 0,8 cm, vorzugsweise 1 bis 5 cm betragen.

Die Länge des Federkontaktstiftes kann vorzugsweise mindestens 1 cm und/oder vorzugsweise maximal 8 cm, besonders zweckmäßig 1,5 bis 6 cm betragen.

In der Zeichnung sind Ausführungsbeispiele dargestellt. Es zeigen:

Fig. 1 einen gebrochenen Längsschnitt durch einen Federkontakfstift gemäß einem Ausführungsbeispiel der Erfindung,

Fig. 2 einen gebrochenen Längsschnitt durch einen Federkontaktstift gemäß einem weiteren Ausführungsbeispiel der Erfindung,

Fig. 3 eine Variante eines Details des Federkontaktstiftes nach Fig. 1.

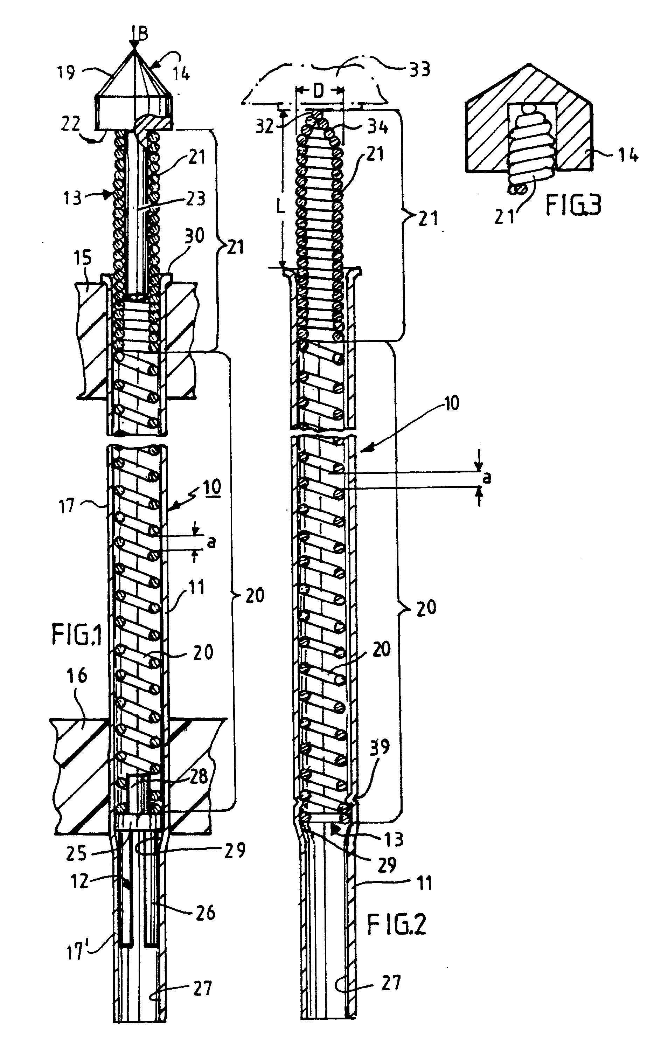

Der in Fig. 1 dargestellte Federkontaktstift 10 besteht aus einer rohrförmigen dünnen rotationssymmetrischen Hülse 11, deren Außendurchmesser vorzugsweise max. 1,5 mm betragen kann, im allgemeinen jedoch noch erheblich kleiner sein kann, bspw. auch kleiner als 1 mm sein kann, einem einstückigen Einsatzstück 12, einer einstückigen Feder 13 und einem einstückigen Kontaktkopf 14. Die Hülse 11 ist einstückig und in zwei ihrer Halterung dienende Tragplatten 15, 16 eines nicht in weiteren Einzelheiten dargestellten Prüfadapters zusammen mit vielen weiteren gleichen Federkontaktstiften 10 eingesetzt, wobei in diesen Prüfadapter ggfs. auch noch andere Kontaktstifte zusätzlich eingesetzt sein können, bspw. pneumatische Kontaktstifte. Eine einen Abschnitt der Feder 13 bildende Schraubenfeder 21 und der Kontaktkopf 14 bilden hier zusammen das mittels einer den restlichen Bereich der Feder 13 bildenden Schraubendruckfeder 20 federnd abgestützte Kontaktelement dieses Federkontaktstiftes 10.

Der die Feder 13 enthaltende langgestreckte Bereich 17 der Hülse 11 ist wie dargestellt mit Ausnahme des oberen Randflansches 30 zylindrisch, also im wesentlichen zylindrisch, vorzugsweise kreiszylindrisch. Die Hülse verlängert sich danach etwas bis zu einem kurzen zylindrischen unteren Endbereich 17'.

Der Federkontaktstift 10 dient dem Kontaktieren von Prüflingen, bspw. Leiterplatten oder dergl. Der Kontaktkopf 14 wird an die durch ihn jeweils zu kontaktierenden Stellen des betreffenden Prüflings angedrückt, um diese Stelle elektrisch mit einem an den Prüfadapter angeschlossenen Testgerät der betreffenden Prüfvorrichtung zu verbinden, die die Prüflinge auf elektrische Fehlerfreiheit prüft. Dieser Kontaktkopf 14 kann hierzu irgendeine geeignete Ausbildung aufweisen. In diesem Ausführungsbeispiel weist er eine konische Spitze 19 auf, doch kann er auch andere geeignete Ausbildungen haben, bspw. mit Schneiden versehen sein, nadelförmig sein oder dergl.

Dieser Kontaktkopf 14 ist auf die Feder 13 aufgesteckt, die jetzt näher beschrieben wird.

Die aus einem einzigen Runddraht - ggfs. kann auch ein Profildraht mit unrundem, bspw. rechteckförmigen Profil vorgesehen sein - gewickelte Feder 13 besteht aus zwei unterschiedlich gewickelten Abschnitten. Ihr Längsabschnitt 20 bildet eine zylindrische Schraubendruckfeder, die axial stark zusammendrückbar ist, indem ihre Windungen sich nicht berühren, sondern im entspannten Zustand so viel Abstand a voneinander haben, daß sich der gewünschte Federweg und die für das Kontaktieren des Prüflings jeweils erforderliche Federkraft beim hierbei stattfindenden Zusammendrücken ergibt. Der Abschnitt 21 dieser Feder 13 bildet eine axial nicht zusammendrückbare zylindrische Schraubenfeder, indem ihre Windungen in diesem Ausführungsbeispiel im Ruhezustand mit oder ohne Vorspannung aneinander anliegen. Wie dargestellt, hat die Schraubenfeder 21 ungefähr denselben Windungsdurchmesser wie die Schraubendruckfeder 20, so daß die aus ihnen bestehende Gesamtfeder eine ungefähr zylindrische Schraubenfeder 13 ist, vorzugsweise eine zylindrische Schraubenfeder ist. Unter Windungsdurchmesser versteht man den mittleren Windungsdurchmesser. Im Hinblick auf den konstanten Drahtquerschnitt ergibt sich jedoch, daß,wenn die mittleren Windungsdurchmesser unter sich ungefähr gleich groß sind, daß dann auch die äusseren Windungsdurchmesser (= Windungsaussendurchmesser) unter sich ebenfalls ungefähr gleich groß sind. Es kann in manchen Fällen auch vorgesehen sein, daß die Windungen der Schraubenfeder 21 geringen Abstand voneinander haben, der kleiner als a ist, damit diese Schraubenfeder 21 den Schaft 23 des Kontaktkopfes 14 halten kann. Die Windungszahl/cm (also die Anzahl der Windungen pro Zentimeter Federlänge) ist für die Schraubenfeder 21 also größer als für die Schraubendruckfeder 20. Auch das Verhältnis Z/D, wo Z = Windungsanzahl/cm und D = Windungsaußendurchmesser bedeutet, ist für die Schraubenfeder 21 wesentlich größer als für die Schraubendruckfeder 20, da D für die Federn 20 und 21 gleichgroß oder annähernd gleich groß ist, nicht jedoch Z, den Z ist für die Schraubenfeder 21 größer, vorzugsweise wesentlich größer als für die Schraubendruckfeder 20. Die Eigensteifigkeit der Schraubenfeder 21 ist so groß und/oder sie wird durch den in sie reibungsschlüssig eingesteckten Schaft 23 so versteift, daß sie bei der Prüfung von Prüflingen nicht knicken kann, wenn die Feder 13 dabei durch in Richtung des Pfeiles B auf den Kontaktkopf ausgeübte Druckkräfte belastet wird und damit sie auch durch das Gewicht des Kontaktkopfes 14 in ihrer unbelasteten Betriebsstellung nicht gebogen wird.

Der Bereich 21 der Feder 13 sei als Schraubenfeder und der Bereich 20 als Schraubendruckfeder bezeichnet, um diese beiden Bereiche unterschiedlich zu benennen. Die Schraubenfeder 21 führt vom vorderen Ende der Feder 13, das an einem Ringbund 22 des Kontaktkopfes 14 anliegt, in entspanntem Zustand der Feder 13 bereits ein kurzes Stück weit axial in die rohrförmige Hülse 11 wie dargestellt hinein, damit diese Schraubenfeder 21 in der Hülse 11 so geführt ist, daß ihre Längsachse koaxial zur Hülse 11 verläuft. Der jeweils in der Hülse 11 befindliche Bereich der Schraubenfeder 21 bildet praktisch einen Kolben, da er in der Hülse 11 mit geringem Gleitlagerspiel geführt ist. Sein Außendurchmesser ändert sich nicht, so daß gleichbleibend gute Führung dieses "Kolbens" in der Hülse 11 gewährleistet ist. Dieser "Kolben" ist jedoch nicht starr, sondern biegsam und ergibt so besonders gute Anpassung an die Hülse 11 auch dann, wenn diese sich etwas biegen sollte. Die Schraubendruckfeder 20 kann denselben Windungsaußendurchmesser wie die Schraubenfeder 21 erhalten, wenn für sie nicht die Gefahr besteht, daß sie durch ihr beim Zusammendrücken entstehendes geringfügiges Aufweiten sich an die Innenwand der Hülse 11 störend andrückt. Besteht letztere Gefahr, kann ihr Windungsaußendurchmesser geringfügig kleiner als der Windungsaußendurchmesser der Schraubenfeder 21 gemacht werden. Würde die Schraubenfeder 21 nicht in die Hülse 11 hineinragen oder nur sehr wenig, dann bestünde die Gefahr, daß sie infolge der Schraubendruckfeder 20 aus ihrer mit der Hülse 11 fluchtenden Lage durch das Eigengewicht bzw. das Gewicht des Kontaktkopfes 14 herausgelangen kann und dann kein präzises Kontaktieren der durch diesen Federkontaktstift zu kontaktierenden Stellen von Prüflingen mehr möglich wäre. Andererseits ermöglicht diese Schraubenfeder 21 jedoch, wie bereits dargelegt, daß beim exzentrischen Auftreffen des Kontaktkopfes 14 auf einen zu kontaktierenden Bohrungsrand einer Leiterplatte oder dergl. sich dieser Kopf 14 unter entsprechendem geringem Biegen der Schraubenfeder 21 und ggf. des sehr dünnen Schaftes 23, der vorzugsweise aus elastischem Metall besteht, zu diesem Bohrungsrand ohne Beschädigungsgefahr des Federkontaktstiftes 10 zentrieren kann.

Die Schraubenfeder 21 ist in den Ausführungsbeispielen erheblich kürzer als die Schraubendruckfeder 20. Der im unbelasteten Zustand über die Hülse 11 überstehende Bereich der Länge L der Schraubenfeder 21 ist mehrfach größer als der maximale Außendurchmesser D (Fig. 2) dieses überstehenden Bereiches. Vorzugsweise kann L/D mindestens 4 : 1, besonders zweckmäßig mindestens 5 : 1 betragen.

Der Kontaktkopf 14 weist in diesem Ausführungsbeispiel den zylindrischen Schaft 23 auf, der in die Schraubenfeder 21 eingesteckt ist und sie hierdurch etwas aufgeweitet hat, so daß hierdurch der Kontaktkopf 14 reibungsschlüssig an der Schraubenfeder 21 gehalten ist. Dabei ist es besonders günstig, wenn, wie dargestellt, im entspannten Zustand der Schraubendruckfeder 20 dieser Schaft 23 noch ein kurzes Stück in die Hülse 11 hineinragt, wodurch der Schaft 23 die Schraubenfeder 21 besonders gut zusätzlich versteifen kann. Der im Bereich der Feder 13 konstante Innendurchmesser der Hülse 11 ist geringfügig größer als der Außendurchmesser, d. h. der Windungsaußendurchmesser der Feder 13, derart, daß die Feder 13 auf ihrem sich jeweils innerhalb des betreffenden kreiszylindrischen Bereichs der Hülse 11 befindlichen Bereich durch die Hülse 11 geführt ist, wobei diese Feder 13 jedoch mit Ausnahme ihres unteren, gehaltenen Endes in der Hülse mit geringem Gleitlagerspiel auch dann noch gleiten kann, wenn die Schraubendruckfeder 20 durch das Kontaktieren von Prüflingen entsprechend zusammengedrückt ist.

Der Schaft 23 versteift die Schraubenfeder 21, so daß sie auch unter extremen Bedingungen nicht knicken kann. Auch erlaubt der Schaft 23, daß die Feder 13 aus besonders dünnem Draht gewickelt werden kann.

Das rückwärtige Ende der Schraubendruckfeder 20 liegt an einem Auflager an, das als Ringbund 25 des Einsatzstückes 12 ausgebildet ist. Der Ringbund 25 liegt an einer durch eine Verringerung des Durchmessers der Hülse 11 gebildeten Innenschulter 29 der Hülse 11 an und ragt mit einem rückwärtigen, geschlitzten Fuß 26 in den zylindrischen, im Durchmesser verkleinerten rückwärtigen Endbereich 27 der Hülse sich hier durch Reibung selbsthaltend hinein. Auf der anderen Seite des Ringbundes 25 ist ein stiftförmiger Vorsprung 28 angeordnet, auf den die Schraubendruckfeder 20 sich auf ihm durch Reibung selbsthaltend aufgesteckt ist. Damit hält sich das Einsatzstück 12 nur durch Reibung in der Hülse 11 und die Feder 13 wiederum ebenfalls nur durch Reibung auf dem Einsatzstück 12, und der Kontaktkopf 14 hält sich ebenfalls nur mit Reibung auf der Schraubenfeder 21, so daß diese Teile lösbar miteinander verbunden sind und leicht und rasch zum fertigen Federkontaktstift zusammengesteckt und auch wieder auseinander genommen werden können, bspw. zwecks Auswechseln eines beschädigten Teiles.

Der rückwärtige Endbereich 27 der Hülse 11 kann als elektrischer Anschluß dieses Federkontaktstiftes 10 dienen, indem bspw. an ihn ein weiterführender Leiter angeschlossen, z.B. angelötet ist. Es ist auch möglich, einen solchen weiterführenden Leiter in eine Bohrung des Einsatzstückes 12 einzusetzen. Auch andere Anschlußmöglichkeiten bestehen, bspw. Einstecken eines Steckers in den Abschnitt 27 der Hülse 11.

Die Hülse 11 ist am vorderen Ende zu einem schmalen Ringflansch 30 aufgeweitet, welcher an der Vorderseite der vorderen Platte 15 des Prüfadapters anliegt, so daß dieser Federkontaktstift 10 hierdurch gegen die auf ihn beim Prüfen von Prüflingen in Richtung des Pfeiles B einwirkenden Kräften abgestützt ist und es hierzu keiner sonstigen anderen Maßnahmen bedarf.

Dieser Federkontaktstift 10 ist kostengünstig herstellbar, weist nur wenige rasch und einfach zu montierende Teile auf und läßt sich auch gewünschtenfalls wieder in seine Einzelteile zwecks Austauschens von beschädigten Teilen zerlegen. Auch kann der Kontaktkopf 14 gegen andere Kontaktköpfe ausgewechselt werden. Der Federkontaktstift 10 ist wegen der Möglichkeit des Biegens der Schraubenfeder 21 beim Kontaktieren von Prüflingen nicht mehr der Beschädigungsgefahr wie die bekannten Federkontaktstifte mit starren Kolben ausgesetzt. Auch ist bei der Herstellung dieses Federkontaktstiftes keine Bördelung an der Hülse vorzunehmen.

Der Federkontaktstift 10 nach Fig. 2 unterscheidet sich von dem nach Fig. 1 einmal dadurch, daß das vordere Ende der Schraubenfeder 21 sich am vorderen Endbereich 34 kegelförmig verjüngt, so daß das vordere Ende 32 die dem Inkontaktkommen mit Prüflingen 33 dienende Kontaktspitze dieses Federkontaktstiftes 10 wie dargestellt bildet. Um dies besonders deutlich zu zeigen, ist in Fig. 2 ein Prüfling 33 strichpunktiert mit eingezeichnet, wie er gerade in Kontakt mit dieser Kontaktspitze 32 kommt. Die Eigensteifigkeit der hier nicht durch einen Schaft versteiften Schraubenfeder 21 ist so groß, daß ihr über die Hülse 11 überstehender Bereich zumindest in der vorgesehenen Betriebsstellung des Federkontaktstiftes 10 im unbelasteten Zustand gerade und in Fluchtung mit der Hülse 11 ist und ihm die für die Prüfung von Prüflingen , wie 33, ausreichende Knickfestigkeit gegeben ist, so daß dieser überstehende Bereich im Betrieb nicht knicken kann. Auch kann der Windungsaußendurchmesser des konstanten Windungsaußendurchmesser aufweisenden Bereichs der Schraubenfeder 21 gleich oder nahezu gleich dem konstanten Windungsaußendurchmesser der Schraubendruckfeder 20 entsprechen.

Man kann jedoch auch vorsehen, auf den vorderen Bereich der Schraubenfeder 21 einen gesonderten Kontaktkopf 14 aufzustecken, wie es Fig. 3 an einem Ausführungsbeispiel zeigt. In Fig. 3 ist nur der vordere Endbereich der Feder 13 des nicht in weiteren Einzelheiten dargestellten Federkontaktstiftes dargestellt.

Dieser Kontaktkopf 14 in Fig. 3 kann vorzugsweise auch nur lösbar auf der Schraubenfeder 21 gehalten sein, oder er kann auch bspw. durch Laserschweißen mit der Schraubenfeder 21 fest verbunden sein.

Der in Fig. 2 dargestellte Federkontaktstift 10 unterscheidet sich von dem nach Fig. 1 ferner noch dadurch, daß das Einsatzstück 12 weggelassen und an seiner Stelle die Schraubendruckfeder 20 direkt auf der Innenschulter 29 der Hülse aufsitzt. Diese Schraubendruckfeder kann hier bspw. dadurch gehalten werden, indem sie an die Hülse angelötet oder angeschweißt wird, bspw. mittels Laserschweißen. Oder sie kann formschlüssig gehalten sein, indem man die Hülse über ihrer untersten Windung von außen mit einer oder mehreren nach innen gerichteten Eindrückungen 39 versieht, die diese Feder 13 am unteren Ende festhalten.

In dem Ausführungsbeispiel nach Fig. 2 bildet die Schraubenfeder 21 allein das Kontaktelement dieses Federkontaktstiftes 10. Dagegen wird bei den Ausführungsformen nach den Fig. 1 und 3 das Kontaktelement des betreffenden Federkontaktstiftes jeweils durch die Schraubenfeder 21 und den auf ihr angeordneten Kontaktkopf 14 gebildet.

Man kann auch bei einem Kontaktkopf 14 nach Fig. 3 vorsehen, in der Schraubenfeder 21 einen sie versteifenden Stab reibungsschlüssig einzustecken, bspw. vom freien Ende der Schraubendruckfeder 20 aus oder vom freien Ende der Schraubenfeder 21 aus, das dann zylindrisch und nicht wie dargestellt konisch auszubilden ist.

Die Federn 13 können aus irgendwelchen geeigneten metallischen Werkstoffen bestehen, vorzugsweise aus Federstahl, Klaviersaitendraht, rostfreiem Stahl, Nickel-Beryllium oder Kupfer-Beryllium.Der die Feder 13 bildende Draht kann vorzugsweise konstanten kreisrunden Querschnitt, oft zweckmäßig auch nicht kreisrunden Querschnitt, bspw. rechteckigen Querschnitt aufweisen.

**Patentansprüche**

1. Federkontaktstift (10) zum Kontaktieren von zu prüfenden elektrischen oder elektronischen Prüflingen (33), wie Leiterplatten, sonstigen elektrischen Bauelementen oder dergleichen, welcher Federkontaktstift (10) elektrisch leitfähig und zur Anordnung an einer Prüfvorrichtung bestimmt ist und eine gerade, metallische Hülse (11) aufweist, in welcher Hülse (11) eine metallische, gerade Schraubendruckfeder (20) angeordnet ist, die der axialen Federung eines in der Hülse (11) geführten Kontaktelements dient, das über die Hülse (11) in Richtung auf die jeweils zu prüfenden Prüflinge (33) übersteht und ein dem Kontaktieren des jeweiligen Prüflings (33) dienendes freies, metallisches Kontaktende aufweist, wobei das Kontaktelement eine Schraubenfeder (21) besitzt, deren Windungen aneinanderliegen, **dadurch gekennzeichnet,** daß sich an die Schraubendruckfeder (20) die Schraubenfeder (21) einstückig axial anschließt, also aus demselben Draht wie die Schraubendruckfeder (20) besteht, daß die Schraubenfeder (21) im unbelasteten Zustand mit einem Teilbereich in der Hülse (11) geführt ist und mit einem über die Hülse (11) überstehenden Bereich im unbelasteten Zustand gerade und in Fluchtung mit der Hülse (11) ist sowie für die Prüfung von Prüflingen (33) eine ausreichende Knickfestigkeit durch entsprechend große Eigensteifigkeit hat.

2. Federkontaktstift nach Anspruch 1, dadurch gekennzeichnet, daß die Länge des über die Hülse (11) überstehenden Bereichs der Schraubenfeder (21) zumindest in unbelastetem Zustand größer als der maximale Durchmesser dieses Bereiches ist.

3. Federkontaktstift nach Anspruch 1 oder 2, **dadurch gekennzeichnet,** daß die Windungen der Schraubenfeder (21) im unbelasteten Zustand des Federkontaktstifts mit Vorspannung aneinanderliegen.

4. Federkontaktstift nach einem der vorhergehenden Ansprüche, dadurch gekennzeichnet, daß die Schraubenfeder (21) das Kontaktelement allein bildet.

5. Federkontaktstift nach Anspruch 1, 2 oder 3,dadurch gekennzeichnet, daß auf dem freien Endbereich der Schraubenfeder (21) ein metallischer Kontaktkopf (14) angeordnet ist, der dem Inkontaktkommen mit den jeweils zu prüfenden Prüflingen dient, wobei vorzugsweise der Kontaktkopf (14) einen in die Schraubenfeder eingesteckten und in ihr vorzugsweise reibungsschlüssig gehaltenen Schaft (23) oder eine Bohrung, in die die Schraubenfeder (21) eingesetzt ist, aufweist.

6. Federkontaktstift nach einem der vorhergehenden Ansprüche, dadurch gekennzeichnet, daß die Hülse (11) ein beidseits offenes Rohr ist und/oder daß die Hülse (11) rotationssymmetrisch ausgebildet ist.

7. Federkontaktstift nach einem der vorhergehenden Ansprüche, dadurch gekennzeichet, daß in der Hülse ein Auflager (12) für die Schraubendruckfeder angeordnet ist, das vorzugsweise einen in die Schraubendruckfeder (20) zu deren Halterung hineinragenden, stabförmigen Ansatz (28) aufweist.

8. Federkontaktstift nach einem der vorhergehenden Ansprüche, dadurch gekennzeichnet, daß die Schraubendruckfeder (20) oder das Auflager auf einer durch eine Verengung der Hülse gebildeten Innenschulter (29) der Hülse aufsitzt.

9. Federkontaktstift nach einem der vorhergehenden Ansprüche, dadurch gekennzeichnet, daß die Windungen der Schraubenfeder (21) am vorderen Endbereich (34) mit sich in Richtung auf ihr freies Ende zu verringerndem Radius gewickelt sind und der übrige Bereich der Schraubenfeder (21) konstanten Windungsdurchmesser aufweist, der dem konstanten Windungsdurchmesser der Schraubendruckfeder (20) entspricht.

10. Federkontaktstift nach einem der vorhergehenden Ansprüche, dadurch gekennzeichnet, daß die Schraubendruckfeder (20) an ihrem rückwärtigen Ende an der Hülse befestigt ist, vorzugsweise das rückwärtige Ende der Schraubendruckfeder (20) an die Hülse angelötet oder angeschweißt oder durch mindestens eine Eindrückung in der Hülse gehalten ist.

11. Federkontaktstift nach einem der vorhergehenden Ansprüche, dadurch gekennzeichnet, daß zumindest der in der Hülse (11) befindliche Bereich der Schraubenfeder (21) und der bewegliche Bereich der Schraubendruckfeder (20) in der Hülse, vorzugsweise in einem kreiszylindrischen Bereich der Hülse, mit geringem Seitenspiel geführt sind.

12. Federkontaktstift nach einem der vorhergehenden Ansprüche, dadurch gekennzeichnet, daß der Windungsdurchmesser der Schraubendruckfeder (20) über ihre Länge konstant ist und daß der Windungsdurchmesser der Schraubenfeder (21) ebenfalls konstant ist.

13. Federkontaktstift nach einem der vorhergehenden Ansprüche, dadurch gekennzeichnet, daß die vordere Mündung der Hülse (11) unverengt ist und vorzugsweise einen nach außen gerichteten Ringflansch (30) aufweist und/oder daß der Schaft (23) des Kontaktkopfes (14) sich im unbelasteten Zustand des Kontaktelementes (14; 21) bis in die Hülse (11) hineinerstreckt und/oder daß die aus der Schraubendruckfeder (20) und der Schraubenfeder (21) bestehende Feder (13) ggfs. mit Ausnahme des freien Endbereiches (34) der Schraubenfeder (20) ungefähr konstanten Windungsaußendurchmesser aufweist.

**Claims**

1. Spring-loaded contact pin (10) for contacting electric or electronic test specimens (33) to be tested, such as printed circuit boards, other electric components or the like, said spring-loaded contact pin (10) being electrically conductive and intended for arrangement on a testing apparatus and comprising a straight, metallic sleeve (11), a metallic, straight helical compression spring (20) being arranged in said sleeve (11) for axial suspension of a contact element in said sleeve (11), said contact element protruding beyond said sleeve (11) in the direction towards the respective test specimens (33) to be tested and comprising a free, metallic contact end for contacting the respective test specimen (33), said contact element having a helical spring (21), the windings of which rest against one another, characterized in that said helical spring (21) integrally adjoins said helical compression spring (20) in the axial direction, i.e., consists of the same wire as said helical compression spring (20), in that said helical spring (21) is guided with a partial region in said sleeve (11) in the unloaded state and with a region protruding beyond said sleeve (11) is straight and in alignment with said sleeve (11) in the unloaded state, and for the testing of test specimens (33) has an adequate resistance to buckling owing to a correspondingly large degree of inherent stiffness.

2. Spring-loaded contact pin as defined in claim 1, characterized in that the length of the region of said helical spring (21) protruding beyond said sleeve (11) at least in the unloaded state is greater than the maximum diameter of this region.

3. Spring-loaded contact pin as defined in claim 1 or 2, characterized in that the windings of said helical spring (21) rest against one another with pretension in the unloaded state of said spring-loaded contact pin.

4. Spring-loaded contact pin as defined in one of the preceding claims, characterized in that said helical spring (21) forms said contact element alone.

5. Spring-loaded contact pin as defined in claim 1, 2 or 3, characterized in that there is arranged on the free end region of said helical spring (21) a metallic contact head (14) for entering into contact with the respective test specimens to be tested, said contact head (14) preferably comprising a shaft (23) inserted into said helical spring and preferably held in a frictionally engaging manner therein or a bore into which said helical spring (21) is inserted.

6. Spring-loaded contact pin as defined in one of the preceding claims, characterized in that said sleeve (11) is a tube which is open on both sides and/or in that said sleeve (11) is of symmetrical design with respect to rotation.

7. Spring-loaded contact pin as defined in one of the preceding claims, characterized in that there is arranged in said sleeve an abutment (12) for said helical compression spring which preferably comprises a rod-shaped attachment (28) protruding into said helical compression spring (20) to hold the latter.

8. Spring-loaded contact pin as defined in one of the preceding claims, characterized in that said helical compression spring (20) or said abutment rests on an inside shoulder (29) formed by a narrowing of said sleeve.

9. Spring-loaded contact pin as defined in one of the preceding claims, characterized in that the windings of said helical spring (21) are wound at the front end region (34) with a radius which decreases towards its free end and the remaining region of said helical spring (21) has a constant winding diameter which corresponds to the constant winding diameter of said helical compression spring (20).

10. Spring-loaded contact pin as defined in one of the preceding claims, characterized in that said helical compression spring (20) is attached at its rear end to said sleeve, said rear end of said helical compression spring (20) preferably being soldered or welded to said sleeve or held by at least one indentation in said sleeve.

11. Spring-loaded contact pin as defined in one of the preceding claims, characterized in that at least the region of said helical spring (21) located in said sleeve (11) and the movable region of said helical compression spring (20) in said sleeve, preferably in a circular-cylindrical region of said sleeve, are guided with slight play at the sides.

12. Spring-loaded contact pin as defined in one of the preceding claims, characterized in that the winding diameter of said helical compression spring (20) is constant throughout its length, and in that the winding diameter of said helical spring (21) is likewise constant.

13. Spring-loaded contact pin as defined in one of the preceding claims, characterized in that the front mouth of said sleeve (11) is not narrowed and preferably comprises an outwardly oriented annular flange (30), and/or in that said shaft (23) of said contact head (14) extends in the unloaded state of said contact element (14; 21) as far as into said sleeve (11), and/or in that said spring (13) comprised of said helical compression spring (20) and said helical spring (21), possibly with the exception of said free end region (34) of said helical spring (20), has an approximately constant winding outer diameter.

**Revendications**

1. Tige de contact à ressort (10) pour établir des contacts avec des dispositifs électriques ou électroniques à tester (33), tels que des cartes à circuits imprimés, d'autres composants électriques ou analogues, tige de contact à ressort (10) qui est électriquement conductrice, destinée à être placée sur un appareil de test et pourvue d'un fourreau métallique droit (11) dans lequel est disposé un ressort hélicoïdal de compression (20) en métal, de forme droite, qui sert au montage élastique axial d'un élément de contact guidé dans le fourreau (11), élément qui dépasse du fourreau (11) en direction des dispositifs à tester (33) et présente une extrémité de contact métallique libre pour établir le contact avec le dispositif à tester (33) concerné, l'élément de contact possédant un ressort à boudin (21) dont les spires sont jointives, caractérisée en ce que le ressort à boudin (21) se raccorde axialement d'un seul tenant au ressort hélicoïdal de compression (20), de sorte qu'il est formé du même fil que le ressort hélicoïdal de compression (20), et que le ressort à boudin (21) à l'état non chargé est guidé par une partie dans le fourreau (11), comporte une partie dépassant du fourreau (11) qui, à l'état non chargé, est droite et alignée avec le fourreau (11), et possède, grâce à une grande rigidité propre, une résistance au flambage suffisante pour tester des dispositifs à tester (33).

2. Tige de contact à ressort selon la revendication 1, caractérisée en ce que la longueur de la partie du ressort à boudin (21) dépassant du fourreau (11) est plus grande que le diamètre maximal de cette partie, tout au moins à l'état non chargé.

3. Tige de contact à ressort selon la revendication 1 ou 2, caractérisée en ce que les spires du ressort à boudin (21) sont appliquées avec précontrainte l'une contre l'autre à l'état non chargé de la tige de contact à ressort.

4. Tige de contact à ressort selon une des revendications précédentes, caractérisée en ce que le ressort à boudin (21) forme à lui seul l'élément de contact.

5. Tige de contact à ressort selon la revendication 1, 2 ou 3, caractérisée en ce qu'une tête de contact métallique (14), destinée à entrer en contact avec les dispositifs à tester, est placée sur la portion terminale libre du ressort à boudin (21), la tête de contact (14) présentant de préférence une queue (23) enfichée dans le ressort à boudin et maintenue dans celui-ci, de préférence par friction, ou un perçage dans lequel est engagé le ressort à boudin (21).

6. Tige de contact à ressort selon une des revendications précédentes, caractérisée en ce que le fourreau (11) est un tube ouvert des deux côtés et/ou que le fourreau (11) est à symétrie de révolution.

7. Tige de contact à ressort selon une des revendications précédentes, caractérisée en ce qu'un appui (12) pour le ressort hélicoïdal de compression est disposé dans le fourreau et est muni de préférence d'une saillie (28) en forme de barreau qui pénètre dans le ressort hélicoïdal de compression (20) en vue du maintien de ce ressort.

8. Tige de contact à ressort selon une des revendications précédentes, caractérisée en ce que le ressort hélicoïdal de compression (20) ou l'appui repose sur un épaulement (29) formé à l'intérieur du fourreau par un rétrécissement du fourreau.

9. Tige de contact à ressort selon une des revendications précédentes, caractérisée en ce que les spires de la portion terminale antérieure (34) du ressort à boudin (21) sont formées par enroulement avec un rayon qui diminue en direction de l'extrémité libre de ce ressort, tandis que la partie restante du ressort à boudin (21) comporte des spires dont le diamètre constant correspond au diamètre constant des spires du ressort hélicoïdal de compression (20).

10. Tige de contact à ressort selon une des revendications précédentes, caractérisée en ce que le ressort hélicoïdal de compression (20) est fixé par son extrémité postérieure au fourreau, de préférence par soudage - à l'aide de matériau d'apport tendre ou avec fusion - de l'extrémité postérieure du ressort hélicoïdal de compression (20) au fourreau, ou est maintenu par au moins une empreinte dans le fourreau.

11. Tige de contact à ressort selon une des revendications précédentes, caractérisée en ce qu'au moins la partie du ressort à boudin (21) située dans le fourreau (11) et la partie du ressort hélicoïdal de compression (20) mobile dans le fourreau, sont guidées avec un faible jeu latéral dans le fourreau, de préférence dans un segment en cylindre circulaire du fourreau.

12. Tige de contact à ressort selon une des revendications précédentes, caractérisée en ce que le diamètre des spires du ressort hélicoïdal de compression (20) est constant sur toute la longueur de ce ressort et que le diamètre des spires du ressort à boudin (21) est également constant.

13. Tige de contact à ressort selon une des revendications précédentes, caractérisée en ce que l'embouchure antérieure du fourreau (11) n'est pas rétrécie et présente de préférence un rebord annulaire (30) dirigé vers l'extérieur et/ou que la queue (23) de la tête de contact (14) s'étend jusque dans le fourreau (11) à l'état non chargé de l'élément de contact (14; 21) et/ ou que le ressort (13) composé du ressort hélicoïdal de compression (20) et du ressort à boudin (21), possède des spires dont le diamètre extérieur est à peu près constant, à l'exception éventuellement de la portion terminale libre (34) du ressort à boudin (21).

FIG.1

FIG.2

FIG.3